# FASCICULE DE BREVET EUROPEEN

(11) **EP 0 818 557 B1**
(45) Date de publication et mention de la délivrance du brevet: **29.08.2001**
(21) Numéro de dépôt: 97870100.1
(22) Date de dépôt: 08.07.1997
(51) Int. Cl.: C23C 14/58

(54) **Procédé et installation pour la formation d'un revêtement sur un substrat**
Verfahren und Vorrichtung zur Herstellung einer Beschichtung auf einem Substrat
Method and apparatus for forming a coating on a substrate

(30) Priorité: 12.07.1996 BE 9600637
(43) Date de publication de la demande: 14.01.1998
(73) Titulaire: RECHERCHE ET DEVELOPPEMENT DU GROUPE COCKERILL SAMBRE, en abrégé: RD-CS, 4000 Liège (BE)
(72) Inventeur: Vanden Brande, Pierre, 1040 Bruxelles (BE); Weymeersch, Alain, 1300 Wavre (BE)
(74) Mandataire: Callewaert, Jean

(56) Documents cités:
- EP-A- 0 655 515
- GB-A- 2 197 346
- US-A- 3 594 238
- US-A- 4 740 385
- PATENT ABSTRACTS OF JAPAN vol. 006, no. 049 (C-096), 31 mars 1982 & JP 56 163262 A (ULVAC CORP), 15 décembre 1981,
- Handbook of deposition technologies for films and coatings, Rointan F. Bunshah, Noyes publications
- Advanced techniques for surface engineering, W. Gissler and H. A. Jehn, Kluwer Academic Publishers

## Description

La présente invention est relative à un procédé pour le dépôt, sur un substrat, d'un revêtement constitué essentiellement d'un composé conducteur électronique.

Suivant une des techniques connues jusqu'à présent, l'on forme un tel revêtement par pulvérisation cathodique réactive, encore appelée "sputtering réactif". Une telle technique est par exemple décrite dans "HANDBOOK OF DEPOSITION TECHNOLOGIES FOR FILMS AND COATINGS", ROINTAN F. BUNSWAH, NOYES PUBLICATIONS, p. 302-306. Un tel procédé présente surtout l'inconvénient d'une vitesse de dépôt relativement lente par suite de la contamination des cibles utilisées à partir desquelles la pulvérisation est réalisée.

Une autre technique connue est celle de l'évaporation sous vide activée appelée "ARE" (Activated Reactive Evaporation). Une telle technique est par exemple décrite dans "ADVANCED TECHNIQUES FOR SURFACE ENGINEERING", W. GRISSLER et H.A. JEHN, KLUWER ACADEMIC PUBLISHERS, p.. Cette technique pose également un problème de contamination du système d'évaporation, ce qui réduit considérablement le rendement de dépôt.

Un des buts essentiels de la présente invention est de proposer un procédé du type précité permettant de réaliser à grande vitesse un revêtement sur un substrat, conducteur d'électricité ou non, et ceci essentiellement d'épaisseur relativement importante.

Il s'agit, plus particulièrement, d'un procédé de production de masse de couches de composés conducteurs de l'électricité ayant une épaisseur de l'ordre de 1000 Å sur un substrat formé par exemple d'acier au défilé, de verre plat, d'une feuille de papier ou d'un film de plastique.

A cet effet, suivant l'invention, l'on forme ledit revêtement en produisant alternativement, d'une part, dans au moins une zone de dépôt, un ou plusieurs dépôts d'une épaisseur déterminée d'un élément conducteur électronique, tel qu'un métal, un alliage, un semi-conducteur du type dopé N, sur le substrat et, d'autre part, dans au moins une zone de réaction, une ou plusieurs réactions de l'élément ainsi déposé avec des ions d'un gaz réactif qui sont implantés dans le dépôt de l'élément susdit sur sensiblement toute cette épaisseur déterminée de manière à former avec sensiblement la majorité et de préférence la quantité totale de cet élément, ledit composé, les ions susdits étant soumis à une énergie cinétique inférieure à 2000V, de préférence de 200 à 900V, tandis que l'épaisseur précitée du dépôt de l'élément est déterminée en fonction de l'énergie cinétique appliquée d'une manière telle à ce que l'implantation de ces ions puisse avoir lieu sur sensiblement toute cette épaisseur.

Avantageusement, l'on effectue la réaction précitée de l'élément déposé sur le substrat avec le gaz réactif précité en créant, en regard et à proximité de la surface de ce dernier présentant le dépôt de l'élément, un plasma dans lequel on introduit le gaz réactif précité, de manière à y former ainsi des ions pénétrant dans le dépôt de l'élément, sensiblement sur une profondeur correspondant à l'épaisseur de ce dépôt pour les faire réagir avec l'élément déposé.

Suivant une forme de réalisation particulière de l'invention, l'on applique, dans la zone de réaction, au substrat un potentiel négatif par rapport à une anode.

Suivant une forme de réalisation avantageuse, le dépôt de l'élément par évaporation, de préférence sous vide, est suivi d'une condensation sur le substrat.

Suivant une forme de réalisation particulièrement avantageuse, l'on forme le dépôt de l'élément sur le substrat par pulvérisation cathodique.

Suivant une forme de réalisation préférée de l'invention, on forme sur le substrat un revêtement constitué d'une couche d'un composé céramique conducteur électronique, par exemple un composé du type TiN, ZrN, TiCN, CrN, VN, NbN, InSnO, obtenu par la réaction d'au moins un métal et d'un gaz réactif, en effectuant d'abord, dans la zone de dépôt, un dépôt dudit métal sur le substrat et, ensuite, dans la zone de réaction, une ionisation du gaz, dans un plasma, formé en regard de ce dépôt, et une implantation de particules ionisées de ce gaz dans ce dépôt de métal, ce dernier étant mis à un potentiel négatif par rapport au gaz ionisé.

L'invention concerne également une installation particulière pour la mise en oeuvre du procédé précité.

Cette installation est caractérisée en ce qu'elle comprend au moins une zone de dépôt, dans laquelle peut se former un dépôt d'un élément conducteur électronique sur le substrat, cette zone de dépôt étant suivie d'au moins une zone de réaction séparée de cette zone de dépôt, où peut être créée une implantation, dans le dépôt susdit de particules pouvant réagir avec cet élément pour former le composé conducteur électronique, des moyens étant prévus pour déplacer, de préférence d'une manière continue, le substrat de la zone de dépôt vers la zone de réaction.

D'autres détails et particularités de l'invention ressortiront de la description donnée ci-après, à titre d'exemples non limitatifs, de quelques formes de réalisation particulières de l'invention avec référence aux dessins annexés.

La figure 1 est une vue schématique en élévation d'une première forme de réalisation, suivant l'invention, d'une installation pour la formation d'un revêtement sur un substrat.

La figure 2 est une vue schématique, analogue à celle de la figure 1, d'une deuxième forme de réalisation, suivant l'invention, d'une installation pour la formation d'un revêtement sur un substrat.

La figure 3 est également une vue schématique analogue à celle des figures 1 et 2, d'une troisième forme de réalisation, suivant l'invention, d'une installation pour la formation d'un revêtement sur un substrat.

La figure 4 est encore une vue schématique d'une quatrième forme de réalisation, suivant l'invention, d'une installation pour la formation d'un revêtement sur un substrat.

Dans les différentes figures, les mêmes chiffres de référence concernent des éléments analogues ou identiques.

D'une façon générale, l'invention consiste à proposer un procédé pour le dépôt, sur un substrat, d'un revêtement constitué essentiellement d'un composé conducteur électronique.

Le substrat peut par exemple être formé de tôles d'acier au défilé, de plaques de verre plat, de feuilles de papier ou de films en matière plastique.

Le revêtement peut être obtenu par la production de masse de couches, par exemple, de composés métalliques ou céramiques dont l'épaisseur est généralement de l'ordre de 500 à 2000 Å. A cet égard, le procédé suivant l'invention, se caractérise par le fait que l'on forme d'abord une couche séparée sur le substrat dans une zone de dépôt d'un élément conducteur électronique, tel qu'un métal, un alliage ou un semi-conducteur du type dopé N, d'une épaisseur déterminée relativement réduite. Ensuite, dans une zone de réaction, qui est séparée de la zone de dépôt, on crée un gaz réactif contenant des ions qui non seulement peuvent réagir avec l'élément précité, mais qui, de plus, possèdent suffisamment d'énergie cinétique pour pouvoir s'implanter sur toute l'épaisseur déterminée précitée du dépôt ou de la couche de l'élément sur le substrat.

Cette énergie cinétique est avantageusement maintenue en dessous de 2000 V, de préférence entre 200 et 900 V, tandis que l'épaisseur déterminée précitée est telle que l'implantation des ions du gaz réactif puisse avoir lieu sur sensiblement toute cette épaisseur et que ces ions puissent réagir avec la totalité de l'élément formant cette couche de dépôt. Ces étapes de dépôt et de réaction subséquente sont répétées autant de fois jusqu'à obtention de l'épaisseur finale désirée du revêtement

Suivant une forme de réalisation avantageuse de l'invention, on crée, dans la zone de réaction, en regard et à proximité du substrat, un plasma, dans lequel on introduit le gaz réactif précité de manière à y former des ions pouvant réagir, par implantation, avec l'élément déposé préalablement sur le substrat.

Pour obtenir l'énergie cinétique nécessaire pour l'implantation des ions du gaz réactif dans la couche de dépôt de l'élément, l'on applique de préférence un potentiel négatif au substrat dans la zone de réaction pour polariser négativement le dépôt déjà formé sur ce substrat et l'on crée, de plus, un circuit de confinement magnétique pour les électrons formés à proximité de la surface du substrat sur laquelle le revêtement est formé.

Le dépôt de l'élément conducteur précité peut être formé par évaporation, de préférence sous vide, suivie d'une condensation sur le substrat, par pulvérisation cathodique, par une combinaison d'une évaporation et d'une pulvérisation cathodique ou encore au moyen d'un canon à ions.

La technique de la combinaison d'une évaporation et d'une pulvérisation cathodique fait l'objet de la demande de brevet belge n° 09501052 (brevet n° 1009838) du même déposant, tandis que les autres techniques constituent généralement des techniques connues en soi. A cet égard, il y a lieu de noter que le canon à ions est généralement moins intéressant que les autres techniques citées.

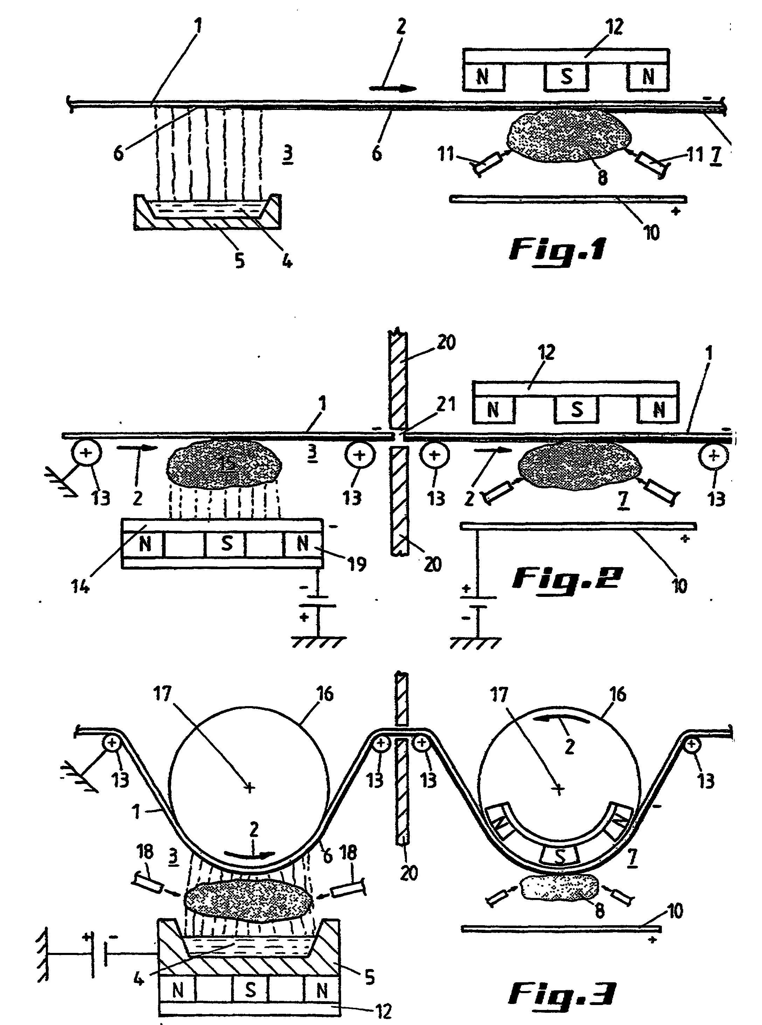

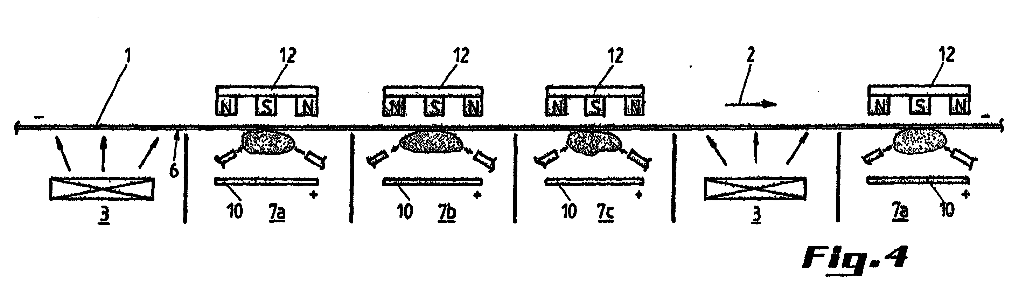

La figure 1 montre schématiquement une forme de réalisation dans laquelle le dépôt de l'élément est formé par évaporation sous vide. Il s'agit d'une forme de réalisation particulière pour le recouvrement d'une des faces d'un substrat 1 en forme d'une feuille continue, qui se déplace d'une manière sensiblement continue dans le sens de la flèche 2, d'abord à travers d'une première zone 3 où a lieu l'évaporation sous vide d'un métal 4 maintenu en fusion dans un creuset 5. Dans cette zone, un film ou une couche 6 de ce métal est condensé sur la face de la tôte en regard du creuset 5. Le substrat 1 avec ce film 6 se déplace ensuite vers une deuxième zone 7, séparée de la première, dans laquelle on produit, dans un gaz réactif par exemple N₂, CH₄, un plasma 8 qui permet de former dans ce gaz des ions. Ces ions s'implantent dans le film 6 pour réagir avec le métal, dont il est constitué, et former ainsi un revêtement 9 d'un composé conducteur électronique obtenu par la réaction du métal formant le film avec les ions produits.

Afin de donner aux ions l'énergie cinétique nécessaire pour pénétrer dans toute l'épaisseur du film 6, on applique au substrat 1, dans la zone 7, un potentiel négatif par rapport à une anode 10 agencée en regard de ce substrat.

Signalons encore que le gaz réactif est introduit dans le plasma 8 par des injecteurs 11 montrés schématiquement à la figure 1 et appelés généralement "douches".

La densité des ions pénétrant dans le film 6 est encore accrue par la présence d'un circuit de confinement magnétique du côté du substrat couvert par ce film. Ce circuit magnétique est créé par des aimants permanents ou éventuellement des électro-aimants 12 montés sur une plaque d'acier doux, représentés schématiquement à la figure 1, disposés à proximité du substrat 1, du côté opposé à celui où est formé le film 6.

La figure 2 est une représentation schématique d'une deuxième forme de réalisation de l'invention qui se rapporte à la formation d'un revêtement sur une des faces de plaques rigides notamment de verre 1 se déplaçant d'une manière sensiblement continue, dans le sens de la flèche 2, sur des rouleaux entraînés 13, mises à la masse, successivement à travers la zone de dépôt 3 et la zone de réaction 7.

Dans cette forme de réalisation, le dépôt du film 6 dans la zone de dépôt 3 est formé par pulvérisation cathodique.

Suivant cette technique, qui est connue en soi, on prévoit dans cette zone 3, en regard des plaques de verre 1, une cible de pulvérisation cathodique magnétron 14 pourvue, du côté dirigé vers ces plaques de verre, d'une couche du métal dont le film 6 est constitué. Cette couche de la cible 14 est bombardée par des ions de gaz inerte, tels que des ions d'argon, formés dans un plasma 15, qui éjectent des atomes de métal de cette cible 14 et forment sur le substrat le film précité 6. Ce gaz inerte est introduit dans la zone de dépôt 3 par des injecteurs inclinés vers le bas.

La cible 14 est mise à un potentiel négatif, tandis que les rouleaux 13 sont également mis à la masse.

La zone de réaction 7, où a lieu l'implantation de ce film d'ions provenant du gaz réactif, est sensiblement identique à celle de la figure 1 et est séparée de la zone de dépôt par une paroi 20 dans laquelle est agencée une ouverture 21 pour le passage des plaques de verre 1 de la zone de dépôt 3 vers la zone de réaction 7.

La figure 3 est une représentation schématique d'une troisième forme de réalisation qui diffère de celle représentée à la figure 2 par la nature du substrat 1, de la technique appliquée pour la formation du film de métal 6 dans la zone de dépôt et des moyens de transport du substrat 1 à travers les zones de dépôt 3 et 7. Dans cette troisième forme de réalisation, le substrat est formé d'une feuille flexible 1, d'un métal, ou d'une feuille souple de papier ou d'une matière plastique, telle que du polyéthylène ou polypropylène, qui est entraînée par des tambours 16 tournant en synchronisme autour de leur axe 17 dans le sens des flèches 2.

Dans la zone de dépôt 3 le film 6 est formé sur le substrat 1 par l'application de la technique combinée d'évaporation sous vide et de pulvérisation cathodique, telle que décrite dans la demande de brevet belge 09501052 du 20 décembre 1996 du même déposant.

Par conséquent, dans ce cas le métal 4 est maintenu à l'état liquide dans un creuset 5 maintenu à un potentiel négatif, en dessous duquel sont agencés des aimants 12 formant un circuit magnétique exactement comme dans la zone de réaction 7 des formes de réalisation précédentes.

La zone de réaction 7, qui suit la zone de dépôt 3 est séparée de cette dernière par une paroi 20, comme dans la deuxième forme de réalisation. Cette zone de réaction 7 se différencie des formes de réalisation précédentes par le fait que la feuille 1 formant le substrat est entraînée sur un tambour 16 et que les aimants 12, formant le circuit magnétique, sont agencés à l'intérieur du tambour, en regard de l'endroit où la feuille 1 est en contact avec ce dernier.

Un des avantages de l'installation suivant la figure 3 est qu'elle permet un refroidissement aisé du substrat aussi bien dans la zone de dépôt que dans la zone de réaction au moyen d'un liquide refroidisseur circulant à l'intérieur des tambours. Ceci peut être utile dans certains cas, par exemple pour le traitement de substrats à point de ramollissement relativement bas ou sujet à des transformations de phases.

La figure 4 est une représentation schématique d'une quatrième forme de réalisation de l'invention dans laquelle la formation du film 6 sur le substrat 1 dans les zones de dépôt 3 peut être réalisée par exemple comme dans les formes de réalisation précédentes.

Ce qui est, toutefois, typique dans cette quatrième forme de réalisation est qu'une zone de dépôt déterminée est séparée de la zone de dépôt subséquente par au moins deux zones de réaction consécutives distinctes. Ainsi, dans la figure 4 on a représenté entre deux zones de dépôt 3, trois zones de réaction consécutives 7a, 7b, 7c où le substrat 1 est soumis à un potentiel qui diffère d'une zone de réaction à la zone de réaction subséquente, de préférence à un potentiel décroissant, dans le sens de déplacement 2 du substrat 1, d'une zone de réaction à la zone de réaction suivante. Concrètement, la différence de potentiel dans la zone 7a peut par exemple être de l'ordre de 3000 V, celui dans la zone 7b de 1000 V et celui dans la zone 7c de 500 V.

L'invention est illustrée davantage par quelques exemples de réalisation concrets décrits ci-après.

### Exemple 1

Cet exemple concerne la formation d'un revêtement de décoration de nitrure de zirconium sur une tôle d'acier en faisant usage d'une installation telle qu'illustrée par la figure 1 dans laquelle toutefois un film de zirconium 6 est déposé sur la tôle 1, à partir d'une cible de zirconium 14, par pulvérisation cathodique, comme dans l'installation montrée à la figure 2.

La tôle d'une épaisseur de 0,2 mm se déplaçait à travers les zones 3 et 7 à une vitesse de l'ordre de 400 m/minute. La largeur de la cible de zirconium 14 dans les zones de réaction 3, suivant le sens de déplacement 2 de la tôle 1, était de 30 cm. Ainsi, le temps de passage de la tôle 1 devant la cible 14 était de 0,045 sec.

Dans cette zone de dépôt 3, on a injecté de l'argon à une pression de 0,667 Pa (5.10⁻³ Torr), tandis que la densité de puissance dissipée à la cible était de 75 W/cm².

Dans la zone de réaction 7, encore appelée zone d'implantation, on a injecté de l'azote également à une pression de 0,667 Pa (5.10⁻³ Torr), alors que la densité de puissance dissipée au substrat lors de l'implantation du film de zirconium était de 20 W/cm³. La tension entre la tôle et l'anode était de 450 V.

En faisant passer la tôle à travers dix sections de ce type, c'est-à-dire une zone de dépôt suivie d'une zone de réaction, on obtenait une tôle recouverte d'une couche finale homogène de nitrure de zirconium d'une épaisseur totate de 700Å pouvant convenir parfaitement pour la décoration.

### Exemple 2

Cet exemple concerne la formation d'une couche d'oxyde d'indium et d'étain (InSnO), encore appelée "ITO", sur des plaques de verre, en faisant usage de l'installation telle qu'illustrée schématiquement par la figure 2 mais, mais dans laquelle, toutefois, la zone de dépôt 3 correspondait à celle de la forme de réalisation montrée à la figure 1. Ainsi, on avait prévu deux creusets successifs formant des cibles, un creuset contenant de l'étain liquide, l'autre contenant de l'indium liquide. La surface du métal liquide dans chacun de ces creusets, exposée aux plaques de verre défilant en regard de ces derniers, présentait une largeur de 30 cm dans le sens de défilement Comme dans le premier exemple, la vitesse de déplacement des plaques était de 400 m/minute.

Dans la zone de dépôt, on a injecté de l'argon à une pression de 0,667 Pa (5.10⁻³ Torr), tandis que la densité de puissance dissipée aux cibles était de 50 W/cm².

La largeur de la zone de réaction, notamment du circuit magnétique défini par les aimants formant un magnétron, était de 30 cm.

Dans cette zone, on a injecté de l'oxygène à une pression de 0,667 Pa (5.10⁻³ Torr).

La tension dans cette zone entre le film composé d'indium et d'étain, préalablement formé dans la zone de dépôt sur les plaques de verre entrant dans la zone de réaction, était de 600 V et la densité de puissance dissipée sur le substrat était de 30 W/cm².

Comme dans l'Exemple 1, on a fait passer ces plaques de verre à travers dix zones de dépôt identiques entre chacune desquelles était intercalée une même zone de réaction. Ceci a permis d'obtenir des plaques de verre recouvertes d'une couche finale homogène et transparente d'oxyde d'indium et d'étain d'une épaisseur de 1000 Å.

### Exemple 3

Cet exemple concerne la formation d'un revêtement de nitrure de titane sur une feuille flexible d'aluminium d'une épaisseur de 0,3 mm en faisant usage d'une installation du type de celle représentée à la figure 3.

Les conditions de travail et paramètres dans les zones de dépôt et de réaction correspondaient sensiblement à celles de l'Exemple 1. Ceci a permis d'obtenir un revêtement homogène de nitrure de titane d'une épaisseur de 500 Å après dix passages successifs à travers une zone de dépôt et une zone de réaction.

## Revendications

1. Procédé pour le dépôt sur un substrat (1) d'un revêtement (6) comprenant un composé conducteur électronique suivant lequel on forme le revêtement, en produisant, d'une part, dans au moins une zone de dépôt (3), un ou plusieurs dépôts d'une épaisseur déterminée d'un élément conducteur électronique; et en produisant, d'autre part, dans au moins une zone de réaction (7) dans laquelle est située une anode (10), une ou plusieurs réactions de l'élément conducteur électronique ainsi déposé avec des ions d'un gaz réactif afin de les implanter dans le dépôt de l'élément susdit sur la majorité de cette épaisseur déterminée de manière à former avec la majorité de cet élément ledit composé conducteur électronique;
dans lequel un potentiel négatif par rapport à l'anode (10) est appliqué dans la zone de réaction (7) au revêtement déposé (6).

2. Procédé suivant la revendication 1, dans lequel le potentiel négatif est appliqué au revêtement déposé en appliquant au substrat un potentiel négatif par rapport à l'anode.

3. Procédé suivant la revendication 1, dans lequel le potentiel négatif est appliqué au revêtement déposé en mettant des rouleaux (13), qui sont en contact avec le revêtement, à la masse.

4. Procédé suivant l'une quelconque des revendications 1 à 3, dans lequel les ions sont soumis à une différence de potentiel inférieure à 2000 V, de préférence de 200 à 900 V.

5. Procédé suivant l'une quelconque des revendications 1 à 4, dans lequel l'on effectue la réaction précitée de l'élément déposé sur le substrat avec le gaz réactif précité en créant, en regard et à proximité de la surface de ce dernier présentant le dépôt de l'élément, un plasma dans lequel on introduit le gaz réactif précité, de manière à y former ainsi des ions pénétrant dans le dépôt de l'élément, sensiblement sur une profondeur correspondant à l'épaisseur de ce dépôt, pour les faire réagir avec l'élément.

6. Procédé suivant rune quelconque des revendications 1 à 5, dans lequel l'on forme le dépôt de l'élément sur le substrat par évaporation, de préférence sous vide, suivie d'une condensation.

7. Procédé suivant l'une quelconque des revendications 1 à 6, dans lequel l'on forme le dépôt de l'élément sur le substrat par pulvérisation cathodique.

8. Procédé suivant l'une quelconque des revendications 5 à 7, dans lequel l'on forme sur le substrat un revêtement constitué d'une couche d'un composé céramique conducteur électronique, par exemple un composé du type TiN, ZrN, TiCN, CrN, VN, NbN, obtenu par la réaction d'un métal et d'un gaz réactif, en effectuant d'abord, dans la zone de dépôt, un dépôt dudit métal sur le substrat et, ensuite, dans la zone de réaction, une ionisation du gaz dans un plasma, formé en regard de ce dépôt, et une implantation de particules ionisées de ce gaz dans ce dépôt de métal, ce dernier étant mis à un potentiel négatif par rapport au gaz ionisé.

9. Procédé suivant l'une quelconque des revendications 1 à 8, dans lequel l'on crée un circuit magnétique de confinement des électrons du côté du substrat où a lieu la réaction de l'élément déposé avec le gaz réactif précité.

10. Procédé suivant l'une quelconque des revendications 1 à 9, dans lequel l'on prévoit, après chaque zone de dépôt de l'élément précité, au moins deux zones de réaction successives séparées, le substrat étant soumis à un potentiel différent d'une zone de réaction à la zone de réaction subséquente.

11. Procédé suivant l'une quelconque des revendications 1 à 10, dans lequel le substrat est formé dune bande continue se déplaçant, de préférence d'une manière sensiblement continue, à travers les zones successives précitées.

12. Procédé suivant l'une quelconque des revendications 1 à 11, dans lequel le substrat étant formé d'une plaque, de telles plaques successives sont déplacées l'une à la suite de l'autre à travers les zones successives, le dépôt formé sur ces plaques dans la zone de dépôt étant mis à un potentiel négatif au moins dans la zone de réaction.

13. Procédé suivant l'une quelconque des revendications 1 à 12, dans lequel une excitation radio-fréquence, de préférence dans la gamme des micro-ondes, est appliquée dans la zone de réaction précitée, à proximité de la surface du substrat sur laquelle l'on forme le revêtement.

14. Installation pour le dépôt, sur un substrat, d'un revêtement constitué essentiellement d'un composé conducteur électronique, notamment installation pour la mise en oeuvre du procédé suivant l'une quelconque des revendications 1 à 13, comprenant au moins une zone de dépôt, dans laquelle peut se former un dépôt d'un élément conducteur électronique sur le substrat, cette zone de dépôt étant suivie d'au moins une zone de réaction séparée de cette zone de dépôt, où peut être créée une implantation, dans le dépôt susdit, de particules pouvant réagir avec cet élément pour former le composé conducteur électronique, des moyens étant prévus pour déplacer le substrat de la zone de dépôt vers la zone de réaction, **caractérisée en ce que** des moyens sont prévus pour appliquer au revêtement, au moins dans la zone de réaction, un potentiel négatif par rapport à une anode agencée dans cette zone en regard du substrat.

15. Installation suivant la revendication 14, dans laquelle la zone de dépôt précitée comprend un dispositif permettant de créer une évaporation, de préférence sous vide, suivie d'une condensation de l'élément sur le substrat.

16. Installation suivant la revendication 14, dans laquelle la zone de dépôt comprend une cible présentant une couche superficielle orientée vers le substrat et contenant l'élément à déposer sur ce dernier, des moyens étant prévus pour former un dépôt de cet élément à partir de cette cible par pulvérisation cathodique.

17. Installation suivant l'une quelconque des revendications 14 à 16, comprenant dans la zone de réaction, des moyens permettant d'ioniser des particules de gaz pouvant s'implanter dans le dépôt de l'élément conducteur électronique précité.

## Patentansprüche

1. Verfahren zur Ablagerung einer Beschichtung (6), die eine elektronenleitende Verbindung umfaßt, auf einem Substrat (1), gemäß welchem man die Beschichtung bildet, indem einerseits, in mindestens einer Ablagerungszone (3), eine oder mehrere Ablagerungen eines elektronenleitenden Elements von vorbestimmter Dicke erzeugt werden und indem andererseits, in mindestens einer Reaktionszone (7), in welcher eine Anode (10) angeordnet ist, eine oder mehrere Reaktionen des so abgelagerten elektronenleitenden Elements mit Ionen eines reaktiven Gases erzeugt werden, um dieselben in die Ablagerung des vorstehend genannten Elements über den Großteil dieser vorbestimmten Dicke hinweg derart zu implantieren, daß sie mit dem Großteil dieses Elements die elektronenleitende Verbindung bilden;
wobei bei dem Verfahren ein in Bezug auf die Anode (10) negatives Potential in der Reaktionszone (7) an die abgelagerte Beschichtung (6) angelegt wird.

2. Verfahren nach Anspruch 1, wobei das negative Potential an die abgelagerte Beschichtung angelegt wird, indem ein in Bezug auf die Anode negatives Potential an das Substrat angelegt wird.

3. Verfahren nach Anspruch 1, wobei das negative Potential an die abgelagerte Beschichtung angelegt wird, indem Rollen (13), die mit der Beschichtung in Kontakt sind, auf Masse gelegt werden.

4. Verfahren nach einem der Ansprüche 1 bis 3, wobei die Ionen mit einer Potentialdifferenz von weniger als 2000 V, vorzugsweise von 200 bis 900 V, beaufschlagt werden.

5. Verfahren nach einem der Ansprüche 1 bis 4, wobei man die vorstehend genannte Reaktion des auf dem Substrat abgelagerten Elements mit dem vorstehend genannten reaktiven Gas bewirkt, indem, gegenüber der und in der Nähe der Oberfläche des letzteren, welche die Ablagerung des Elements aufweist, ein Plasma erzeugt wird, in welches man das vorstehend genannte reaktive Gas einbringt, derart, daß dort so Ionen gebildet werden, welche die Ablagerung des Elements im wesentlichen über eine Tiefe, welche der Dicke dieser Ablagerung entspricht, durchdringen, um sie mit dem Element reagieren zu lassen.

6. Verfahren nach einem der Ansprüche 1 bis 5, wobei man die Ablagerung des Elements auf dem Substrat durch Verdampfung, vorzugsweise unter Vakuum, gefolgt von einer Kondensation, bildet.

7. Verfahren nach einem der Ansprüche 1 bis 6, wobei man die Ablagerung des Elements auf dem Substrat durch Kathodenzerstäubung bildet.

8. Verfahren nach einem der Ansprüche 5 bis 7, wobei man auf dem Substrat eine Beschichtung bildet, die aus einer Schicht einer elektronenleitenden keramischen Verbindung besteht, beispielsweise aus einer Verbindung vom Typ TiN, ZrN, TiCN, CrN, VN, NbN, die durch die Reaktion eines Metalls und eines reaktiven Gases erhalten wird, indem zunächst, in der Ablagerungszone, eine Ablagerung des Metalls auf dem Substrat bewirkt wird und anschließend, in der Reaktionszone, eine Ionisation des Gases in einem Plasma, welches gegenüber dieser Ablagerung gebildet wird, und eine Implantierung von ionisierten Teilchen dieses Gases in die Metallablagerung, wobei die letztere auf ein in Bezug auf das ionisierte Gas negatives Potential gelegt wird, bewirkt wird.

9. Verfahren nach einem der Ansprüche 1 bis 8, wobei man einen Magnetkreis zur Abschirmung der Elektronen bei dem Substrat, wo die Reaktion des abgelagerten Elements mit dem vorstehend genannten reaktiven Gas stattfindet, erzeugt.

10. Verfahren nach einem der Ansprüche 1 bis 9, wobei man nach jeder Zone der Ablagerung des vorstehend genannten Elements mindestens zwei aufeinanderfolgende, getrennte Reaktionszonen vorsieht, wobei das Substrat auf ein Potential gelegt wird, das von einer Reaktionszone zur darauffolgenden Reaktionszone verschieden ist.

11. Verfahren nach einem der Ansprüche 1 bis 10, wobei das Substrat aus einem kontinuierlichen Band gebildet ist, das sich, vorzugsweise im wesentlichen kontinuierlich, durch die vorstehend genannten aufeinanderfolgenden Zonen bewegt.

12. Verfahren nach einem der Ansprüche 1 bis 11, wobei das Substrat aus einer Platte gebildet ist, solche aufeinanderfolgende Platten eine nach der anderen durch die aufeinanderfolgenden Zonen bewegt werden und die auf diesen Platten in der Ablagerungszone gebildete Ablagerung zumindest in der Reaktionszone auf ein negatives Potential gelegt wird.

13. Verfahren nach einem der Ansprüche 1 bis 12, wobei eine Radiofrequenz-Anregung, vorzugsweise im Bereich der Mikrowellen, in der vorstehend genannten Reaktionszone angewandt wird, in der Nähe der Oberfläche des Substrats, auf welcher die Beschichtung gebildet wird.

14. Vorrichtung zur Ablagerung einer Beschichtung, die im wesentlichen aus einer elektronenleitenden Verbindung besteht, auf einem Substrat, insbesondere Vorrichtung zur Durchführung des Verfahrens nach einem der Ansprüche 1 bis 13, umfassend mindestens eine Ablagerungszone, in der sich eine Ablagerung eines elektronenleitenden Elements auf dem Substrat bilden kann, wobei diese Ablagerungszone von mindestens einer Reaktionszone gefolgt wird, die von dieser Ablagerungszone getrennt ist und wo eine Implantierung von Teilchen, die mit diesem Element zur Bildung der elektronenleitenden Verbindung reagieren können, in die vorstehend genannte Ablagerung bewirkt werden kann, wobei Mittel zum Bewegen des Substrats von der Ablagerungszone zu der Reaktionszone vorgesehen sind, **dadurch gekennzeichnet**, daß Mittel zum Anlegen eines in Bezug auf eine in dieser Zone gegenüber dem Substrat angeordnete Anode negativen Potentials an die Beschichtung, zumindest in der Reaktionszone, vorgesehen sind.

15. Vorrichtung nach Anspruch 14, wobei die vorstehend genannte Ablagerungszone eine Einrichtung umfaßt, die es erlaubt, eine Verdampfung, vorzugsweise unter Vakuum, gefolgt von einer Kondensation des Elements auf dem Substrat, zu bewirken.

16. Vorrichtung nach Anspruch 14, wobei die Ablagerungszone ein Target umfaßt, das eine gegen das Substrat gerichtete Oberflächenschicht aufweist und das auf dem letzteren abzulagernde Element enthält, wobei Mittel zum Bilden einer Ablagerung dieses Elements, ausgehend von diesem Target, durch Kathodenzerstäubung vorgesehen sind.

17. Vorrichtung nach einem der Ansprüche 14 bis 16, die, in der Reaktionszone, Mittel umfaßt, welche es erlauben, Gasteilchen zu ionisieren, die sich in die vorstehend genannte Ablagerung des elektronenleitenden Elements implantieren können.

## Claims

1. Process for depositing a coating (6) comprising an electronically conducting compound on a substrate (1), in which process the coating is formed, firstly, by depositing, in at least one deposition zone (3), one or more coatings of a predetermined thickness of an electronically conducting element and, secondly, by carrying out, in at least one reaction zone (7) in which an anode (10) is located, one or more reactions between the electronically conducting element thus deposited and ions of a reactive gas in order to implant them in the coating of the abovementioned element over most of this predetermined thickness so as to form with most of this element the said electronically conducting compound, and in which a negative potential with respect to the anode (10) is applied to the deposited coating (6) in the reaction zone (7) .

2. Process according to Claim 1, in which the negative potential is applied to the deposited coating by applying to the substrate a negative potential with respect to the anode.

3. Process according to Claim 1, in which the negative potential is applied to the deposited coating by earthing the rolls (13) which are in contact with the coating.

4. Process according to any one of Claims 1 to 3, in which the ions are subjected to a potential difference of less than 2000 V, preferably from 200 to 900 V.

5. Process according to any one of Claims 1 to 4, in which the aforementioned reaction between the element deposited on the substrate and the aforementioned reactive gas is carried out by creating, opposite and close to that surface of the substrate having the coating of the element, a plasma into which the aforementioned reactive gas is introduced so as in this way to form therein ions which penetrate the coating of the element approximately to a depth corresponding to the thickness of this coating in order to make them react with the element.

6. Process according to any one of Claims 1 to 5, in which the element is deposited on the substrate by evaporation, preferably vacuum evaporation, followed by condensation.

7. Process according to any one of Claims 1 to 6, in which the element is deposited on the substrate by sputtering.

8. Process according to any one of Claims 5 to 7, in which a coating consisting of a layer of an electronically conducting ceramic compound, for example a compound of the TiN, ZrN, TiCN, CrN, VN, NbN type obtained by the reaction of a metal and a reactive gas, is formed on the substrate by firstly depositing, in the deposition zone, a coating of the said metal on the substrate and, thereafter, in the reaction zone, inducing ionization of the gas in a plasma, formed opposite this coating, and implanting ionized particles of this gas into this metal coating, the latter being at a negative potential with respect to the ionized gas.

9. Process according to any one of Claims 1 to 8, in which a magnetic circuit for electron confinement is created on that side of the substrate where the reaction between the deposited element and the aforementioned reactive gas takes place.

10. Process according to any one of Claims 1 to 9, in which at least two separate successive reaction zones are provided after each deposition zone for depositing the aforementioned element, the substrate being subjected to a potential which differs from one reaction zone to the next reaction zone.

11. Process according to any one of Claims 1 to 10, in which the substrate is formed by a continuous web moving, preferably in an approximately continuous manner, through the aforementioned successive zones.

12. Process according to any one of Claims 1 to 11, in which, the substrate being formed by a sheet, such successive sheets are moved one after the other through the successive zones, the coating formed on these sheets in the deposition zone being at negative potential at least in the reaction zone.

13. Process according to any one of Claims 1 to 12, in which a radio-frequency excitation, preferably in the microwave range, is applied in the aforementioned reaction zone near that surface of the substrate on which the coating is formed.

14. Apparatus for depositing a coating essentially consisting of an electronically conducting compound on a substrate, especially an apparatus for implementing the process according to any one of Claims 1 to 13, comprising at least one deposition zone, in which an electronically conducting element can be deposited on the substrate, this deposition zone being followed by at least one reaction zone, separate from this deposition zone, in which particles can be implanted into the aforementioned coating, which particles are able to react with this element in order to form the electronically conducting compound, means being provided for moving the substrate from the deposition zone towards the reaction zone, **characterized in that** means are provided for applying to the coating, at least in the reaction zone, a negative potential with respect to an anode placed in this zone opposite the substrate.

15. Apparatus according to Claim 14, in which the aforementioned deposition zone comprises a device for producing evaporation, preferable vacuum evaporation, of the element followed by its condensation on the substrate.

16. Apparatus according to Claim 14, in which the deposition zone comprises a target having a surface layer turned towards the substrate and containing the element to be deposited on the latter, means being provided for depositing this element from this target by sputtering.

17. Apparatus according to any one of Claims 14 to 16, comprising, in the reaction zone, means for ionizing gas particles that can be implanted into the coating of the aforementioned electronically conducting element.
